# EUROPEAN PATENT APPLICATION

(11) **EP 4 765 885 A1**
(43) Date of publication of application: **24.06.2026**
(21) Application number: 24222739.5
(22) Date of filing: 23.12.2024
(51) Int. Cl.: H04S 7/00, H03G 5/16

(54) **TUNING DEVICE FOR AN AUDIO PROCESSING SYSTEM**

(71) Applicant: Harman Becker Automotive Systems, Inc., Novi, MI 48377 (US)
(72) Inventor: VON TÜRCKHEIM, Friedrich, 76307 Karlsbad (DE); KREJCI, Philipp Maximilian, 76307 Karlsbad (DE); KLEIN, Johannes, 76307 Karlsbad (DE); NEUMANN, Manfred, 76307 Karlsbad (DE)
(74) Representative: Westphal, Mussgnug & Partner, Patentanwälte mbB

(57) **Abstract**

A system is described that comprises a computing device having one or more processors and a memory. The computing device is configured to receive a first stream of first data. The computing device is further configured to perform an analysis on the first stream of first data at a first time and at a second time that is different from the first time and determine whether there is a change in the first stream of first data between the first time and the second time. In addition, the computing device is configured to, if there is a change in the first stream of first data between the first time and the second time, adjust at least one tuning parameter of an audio tuning algorithm of an audio processing system. The audio processing system is configured to process audio input by means of the audio tuning algorithm to generate audio output.

## Description

### TECHNICAL FIELD

Embodiments of the subject matter disclosed herein relate to the field of audio signal processing, and more particularly to systems and methods for dynamically adapting an audio effect to user preferences and environment changes.

### BACKGROUND

Adding audio effects to an audio signal makes it possible to enhance the listening experience of a user. In conventional systems, the parameters of the audio effects are tuned beforehand, i.e. during manufacturing, and cannot be changed when playing an audio content. The parameters are chosen by the tuning engineer so that they can meet the widest possible range of listener preferences and work for many different listening situations and audio files. However, some of the effect properties are particularly sensitive to changes in the listening situation or in the source content. Further, different listeners may have different preferences and it is not possible to accommodate all user preferences with pre-tuned sound effects. Static tuning may thus result in a poor listening experience. In addition, current audio systems comprise a large number of audio canals, which renders a tuning of the audio system particularly complex.

The inventors herein have recognized the aforementioned issues and developed a system and a method that at least partially address these issues, in particular a tuning system that is able to dynamically adapt an audio effect of an audio processing system to user preferences and to the actual listening situation, thereby improving the user's experience while keeping the computational effort as low as possible.

### SUMMARY

The above-mentioned objective is achieved by the system of claim 1 or 14, as well as by the method of claim 15. The system as herein disclosed receives streams of input data, detects changes in the streams of data, and dynamically adapts tuning parameters of an audio processing system to the detected changes. The tuning parameters in turn dynamically adapt or modify the actual audio technology. The input data may be divided into several streams of data (use cases), wherein, for each stream of data, a change in the parameters of the use case may lead to a change in the tuning parameters. With this, the audio effect can be based on changing attributes that correspond to the actual listening situation, and not the laboratory situation of the tuning engineer. An optimally adjusted audio effect can thus be obtained.

In one example, the disclosure is directed to a system that comprises a computing device having one or more processors and a memory. The computing device is configured to receive a first stream of first data. The computing device is further configured to perform an analysis on the first stream of first data at a first time and at a second time that is different from the first time and determine whether there is a change in the first stream of first data between the first time and the second time. In addition, the computing device is configured to, if there is a change in the first stream of first data between the first time and the second time, adjust at least one tuning parameter of an audio tuning algorithm of an audio processing system. The audio processing system is configured to process audio input by means of the audio tuning algorithm to generate audio output.

In one example, the disclosure is directed to a method that comprises the step of receiving a first stream of first data. The method further comprises the step of performing an analysis on the first stream of first data at a first time and at a second time that is different from the first time and determine whether there is a change in the first stream of first data between the first time and the second time. In addition, the method further comprises the step of, if there is a change in the first stream of first data between the first time and the second time, adjusting at least one tuning parameter of an audio tuning algorithm of an audio processing system. The audio processing system processes audio input by means of the audio tuning algorithm to generate audio output.

### BRIEF DESCRIPTION OF THE DRAWINGS

The embodiments described herein can be better understood with reference to the following description and drawings. The components in the figures are not necessarily to scale, emphasis instead being placed upon illustrating the principles of the embodiments. Furthermore, in the figures, like reference numerals designate corresponding parts. In the drawings:
FIG. 1 schematically illustrates an example of a tuning system in accordance with one or more techniques described herein.
FIG. 2 schematically illustrates interactions of the tuning system of FIG. 1 according to one or more embodiments of the present disclosure.
FIG. 3 schematically illustrates an adaptation model of the tuning system of FIG. 1 according to one or more embodiments of the present disclosure.
FIG. 4 is a flowchart illustrating a method for a tuning system according to one or more embodiments of the present disclosure.

### DETAILED DESCRIPTION

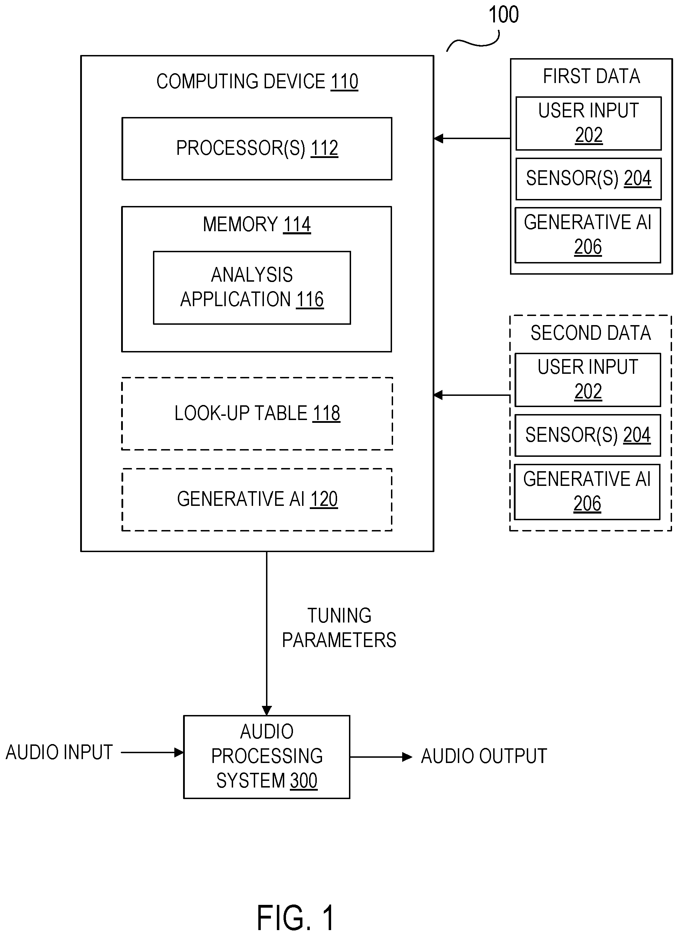

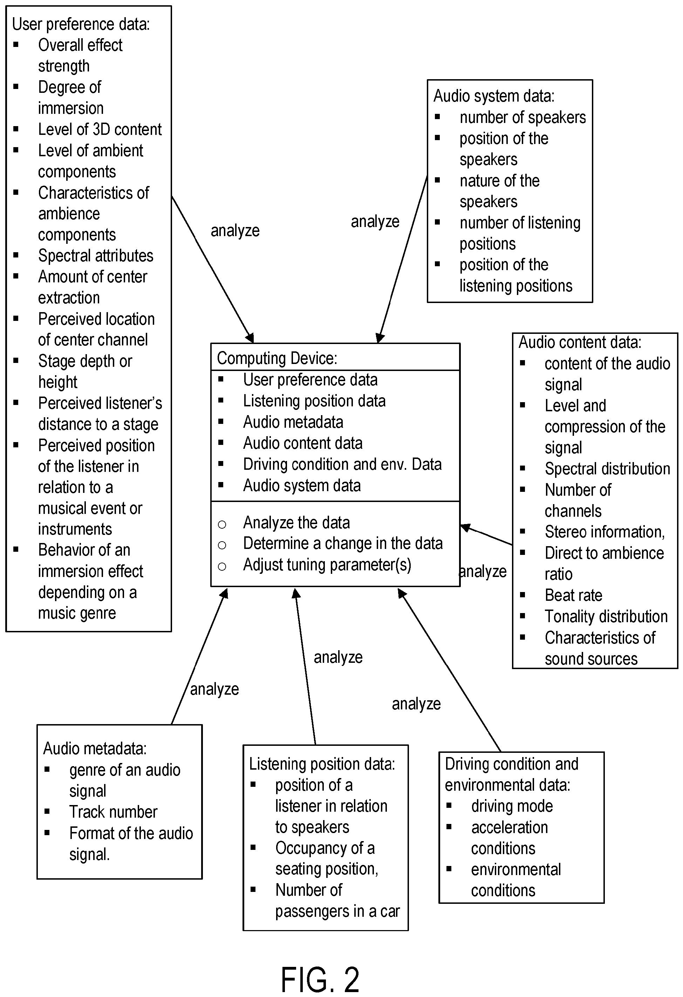

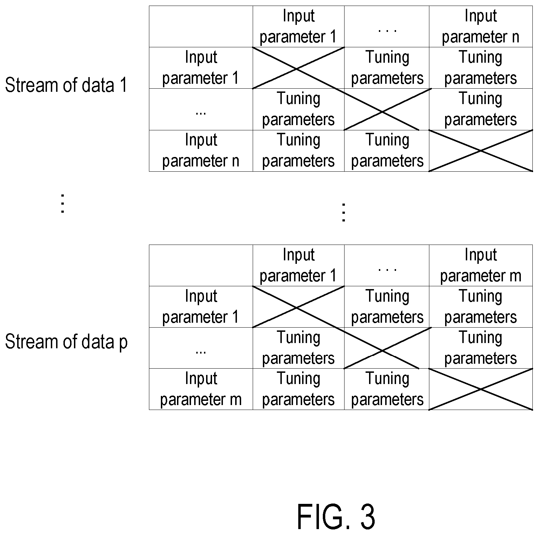

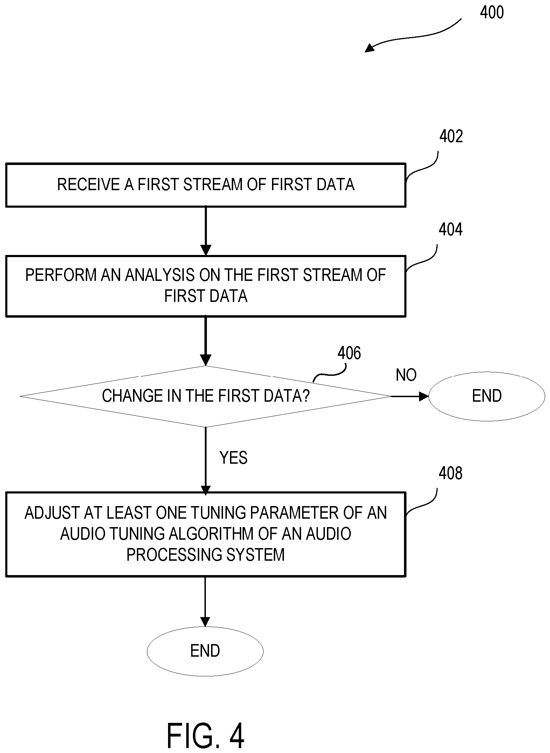

The following description relates to systems for tuning an audio tuning algorithm of an audio processing system. The system herein disclosed receives streams of data that represent user preferences, a listening environment and further audio parameters, and outputs tuning parameters for the audio processing system. FIG. 1 shows a block diagram of a tuning system. FIG. 2 shows a data transmission pattern of the tuning system. FIG. 3 shows an adaptation model of the tuning system. FIG. 4 shows a method for the tuning system.

There is an increasing demand for audio systems that are able to provide a more impressive and more realistic musical experience. For example, immersion effects (e.g. an upmixing technology) are configured to enhance a simple stereo content to a realistic 3D audio content. They make it possible to simulate acoustics of specific venues, such as concert halls or jazz bars, as well as the dynamic placement of sound events around the listener. Such technologies are able to provide a sense of depth and directionality. With this, the listener, who is listening to the audio in a room or in a car, has the impression to be "immersed" in the reproduced sound just as if the user were located in the actual listening environment.

Audio effects in sound systems are usually tuned in a static manner. This means that the tuning takes place during the production process, in which the tuning engineer selects optimal parameters of the audio system for each desired sound effect. These parameters are set and can at best be limitedly changed by the end user (listener). Likewise, a dynamic adaptation to the listening situation, such as a driving mode of a car, a speed of a car, an ambient noise, or the source content itself is not possible. In the case of more complex audio technologies, such as immersion technologies, there is typically a large number of audio tuning parameters for the audio system, such as a degree of envelopment, namely an amount of perceived immersion; a playback level of the speakers; a center channel position; an ambience level; ambience characteristics, which describe the properties of the artificial space; a width of the stage; depth settings; or a perceived position of the listener within the artificial sound event.

During the production tuning process, the characteristics of the audio system for each possible sound effect are set so as to meet the widest possible range of listener preferences, be suitable for many different listening situations, and to work for the widest possible range of audio files. The chosen characteristics are a compromise that is able to reflect as many scenarios and subjective preferences as possible.

However, especially with regard to immersion effects (also called 3D effects) in a multi-channel audio system, some of the effect properties are particularly sensitive to changes in the listening situation or source content and may not work at all in certain situations. For example, part of an artificial reverberation effect may be masked by the ambient noise. The listener may also move to a position in which the tuning of the loudspeakers is no longer optimal. This might the case in a car, in which the number of passengers and their seating locations may vary. The original audio signals may also be modified such that they no longer correspond to the user preferences. For example, a certain group of listeners may prefer a higher level of immersion because they mostly listen to electronic music, while other listeners may prefers a more conservative listening environment for listening to classical music. Further, the sound effect may be set for a specific type of audio signals, such as stereo signals, and does not work effectively for other audio signals, such as mono signals. The static tuning may thus result, in some cases, in a poor listening experience.

The tuning system and method thereof disclosed in this disclosure are able to dynamically adapt tuning parameters for an audio processing system to listener preferences, listening situations and properties of audio signals, so that the desired audio effect can be personalized and work in an optimal manner in the actual listening environment.

The disclosure below mostly refers to the example of immersive audio algorithms. However, the references to 3D audio effects, upmixing technologies or immersive audio technologies, are only possible application examples of the claimed system. In principle, the system can be used for all kinds of audio effects and does not need to be concerned with the problems of spatiality, envelopment or 3D. For example, the system can be used for other types of audio processing, such as levelizing (modification of the dynamic range of the audio signal), equalizing, dynamic processing such as compressing or machine learning, etc.

FIG. 1 schematically illustrates a tuning system 100 in a block diagram. The system 100 comprises a computing device 110, the computing device 110 comprising one or more processors 112 and a memory 114. The computing device 110 is configured to receive to receive, as input, at least a first stream of first data. In the example of an immersion effect, the first data may comprise at least one of: user preference data, listening position data, audio metadata, audio content data, driving condition and environmental context data, and audio system data. The first data may also contain further data that are not linked to the driving conditions. The computing device 110 is also configured to perform an analysis on the first stream of first data at a first time and at a second time that is different from the first time and to determine whether there is a change in the first stream of first data between the first time and the second time. The first time and the second time may be determined by a clock generator of the computing device 110. Further, the computing device 110 is configured to, if there is a change in the first stream of first data, adjust at least one tuning parameter of an audio tuning algorithm of an audio processing system 300. The audio processing system 300 is configured to process audio input by means of the audio tuning algorithm to generate audio output. The audio processing system 300 may add an audio effect to the audio input, such as an immersion effect that give the listener the impression to be in a desired virtual listening environment. The audio effect is tuned by the audio tuning algorithm based on the tuning parameters output by the computing device 120. With this, it is possible to dynamically adapt parameters for an audio effect, such as a multi-channel immersion effect, to attributes of the listening situation, such as listener preferences properties of the listening environment or properties of the processed audio signals. This makes it possible to prevent a compromised tuning and to improve the user's experience.

Computing device 110 may be any kind of device that includes one or more processor(s) 112 such as a system-on-a-chip (SoC). In some embodiments, computing device 110 can be a head unit or other component included in a vehicle system. Generally, computing device 110 may be configured to coordinate the overall operation of the system 100. The embodiments disclosed herein contemplate any technically-feasible system configured to implement the functionality of system 100 via computing device 110. In various embodiments, computing device 110 may be located in various environments including, without limitation, a vehicle environments such as, e.g., consumer vehicles, commercial vehicles, bicycles, motorcycles, wheeled drones; a private room such as, e.g., a living-room or a bedroom; or a public space such as, e.g., a movie theater.

Processor(s) 112 may be any technically-feasible form of processing device configured to process data and execute program code. Processor(s) 112 could include, for example and without limitation, a system-on-chip (SoC), a central processing unit (CPU), a graphics processing unit (GPU), an application specific integrated circuit (ASIC), a digital signal processor (DSP), a field programmable gate array (PFGA), and/or the like. Processor(s) 112 may include one or more processing cores. In operation, processor(s) 112 may be a primary processor of the computing device 110, controlling and coordinate operations of other system components. For example, processor(s) 112 may be configured to execute instructions (e.g., methods, algorithms, processes, etc.) stored in memory 114.

In one example, memory 114 stores an analysis application 116. Memory 114 may include a memory module or a collection of memory modules. Memory 114 may be non-transitory memory or other form of non-volatile memory, random access memory (RAM), or any other feasible type of memory storage system. In various embodiments, processor(s) 112 can execute instructions of the analysis application 116 to implement the overall functionality of the computing device 110 and, thus, to coordinate the operation of the system 100 as a whole. For example, data received by the computing device 110 may be processed by the analysis application 116 to determine whether a change in the at least one stream of data has occurred and to adjust at least one tuning parameter of an audio tuning algorithm of the audio processing system 300. The computing device 110 may then output the tuning parameters in various forms. For example, processor(s) 112 may send a command that includes a set of tuning parameters to the audio processing system 300. In some embodiments, the analysis application 116 may be stored and loaded into the memory 114 for execution.

The audio processing system 300 may be an audio system that is configured to modify an audio source according to one or a plurality of effects, and to output an audio output in the listening environment. In one example, the audio processing system 300 comprises a plurality of microphones and a plurality of loudspeakers. In one example, the listening environment is the interior of a car and the loudspeakers are arranged in the headrests of the car. In another example, the listening environment is the interior of a movie theater and the loudspeakers are arranged in the various walls of the movie theater.

As will be seen below, the adaptation process may be split into different cases. For each case, the computing device 110 may be configured to process a stream of input data and to determine tuning parameters, which, in turn, dynamically adapt or modify the audio processing system 300. The tuning parameters may be different for each case. The computing device 110 is configured to adapt the tuning parameters to the input data, such that a change in the input data, for each case, leads to a change of the tuning parameters. With this, the desired audio effect, such as an immersion effect, can be adapted in a simple manner to changes of the listening environment and/or of the user preferences. The ranges of effective changes of the tuning parameters may be pre-determined or defined by a machine learning algorithm. The described principle can be applied to any form of audio effect and extended to other kinds of effects, such as visual effects.

In the following, the immersion effect will be used as a main example. There may be a large number of tuning parameters. In the example of the immersion effect, tuning parameters may be a strength of the immersion effect, a degree of envelopment (amount of immersion as perceived by the listener), or properties of the desired ambience in which to be immersed, such as characteristics of the audio stage or a perceived position of the listener with regard to the stage and to the loudspeakers.

As mentioned above, the first data may comprise, in the example of the immersion effect, the following types of data: user preference data, listening position data, audio metadata, audio content data, driving condition and environmental context data, and audio system data. Further types of data are also possible depending on the listening environment and the desired sound effect. The first data may comprise only one type of data. The different types of data correspond to different adaptation angles for the tuning parameters of the audio processing system 300. The first data may also be a combination of several types of data when a further type of adaptation is desired. As will be seen below, the computing device 110 may also receive streams of a plurality of data, wherein each set of data may correspond to a particular type of data and a particular type of adaptation. This makes it possible to adjust, for each set of data, corresponding tuning parameters according to a given type of adaptation (e.g. preference-based adaptation, listening position-based adaptation, metadata-based adaptation, content-based adaptation, environment-based adaptation, system-based adaptation). The calculated adjustments may then be output to the audio processing system 300. With this, the calculation complexity can be reduced since the adaptation process is divided into several sub-adaptation processes having a reduced number of input parameters.

The main types of adaptation for an immersion effect are illustrated below. However, as mentioned above, other types of adaptation can also be used depending on the desired sound effect.

In one example, the effect characteristics (tuning parameters) of the audio processing system 300 are adapted to user preferences. The user preference data input to the computing device 110 may comprise one or more of an overall effect strength, a degree of immersion, a level of 3D content (amount of desired perceived immersion), a level of ambient components, characteristics of ambience components (reverberation attributes), spectral attributes, an amount of center extraction (ratio of the center channel sound with respect to the rest of the sound), a perceived location of center channel, a stage depth or height, a perceived listener's distance to a stage, a perceived position of the listener in relation to a musical event or instruments, and a behavior of an immersion effect depending on a music genre. For example, the user may wish that no immersion effect be carried for a podcast content and that a strong immersion effect be carried out when electronic music is played. Typically, audio effects are scalable, i.e. from barely audible to very audible. The overall effect strength defines a measure of the general sound in comparison to the original sound. The degree of immersion is similar to the effect strength, but concerns the content of the 3D signals. For example, a degree of immersion is higher if the perceived effect is that of being on the music stage than if the perceived effect is that of sitting in front of the stage. The level of 3D content measures a degree of envelopment of the 3D sound component, i.e. whether more or less energy comes from the side, from behind and from above. The level of ambient components refers to the level of the components that are generated to achieve a spatial effect (ambience), e.g. early reflections or reverberation. Spectral attributes can be any attributes or parameters that affect the processing of the spectral behavior, such as bass management or equalizations (EQs). The amount of center extraction corresponds to the ratio between the extracted center and the rest of the signal (residuals). It can also be a measure of the width of the perceived center signal.

The above characteristics must be understood as desired parameters for the virtual environment created with the sound effect, in this case the immersion effect. In one example, the user preference data are input by the user via a Human-Machine Interface (HMI). In another example, the user preference data can be collected using a machine learning algorithm that is trained by a large number of user preference data.

In one example, the tuning parameters are adapted to the actual position of the listener or of the listeners. The listening position data may comprise one or more of a position of a listener, an occupancy of a seating position, and a number of passengers in a car. The desired sound effect strongly depends on the listening position. However, the listener may change position during the listening experience and no longer be in an optimal position for enjoying the desired effect. The position of the listener with regard to the speakers is thus important for properly setting the immersion effect. In particular, the tuning for the center position can only be set if the position of the listener in the listening environment is known. The same applies to all other components of the effect, such as the ambience components (e.g. perceived distance to the stage, perceived distance to the loudspeakers).

In a car, as well as in other listening situations, it is not possible to predict the listening position. However, potential positions of the listeners can be pre-defined. It is thus possible to tune the audio processing system based on a car occupancy. In one example, the number of passengers and the seating positions are automatically detected, for example by corresponding sensor such as camera sensors, and the corresponding data are input as listening position data to the computing device 110. When the number of passengers or the occupancy of the seating positions changes, the tuning parameters can be adjusted accordingly.

Further, a degree of importance of the listener (e.g. car passengers) can also be included in the input information. Especially, in a car, a distinction can be made between the driver and the front passenger, or between the driver and children on the back seats. This can be effected by using a weighting matrix in which each seat position and/or each type of passenger is associated with a weighting value. The weighting matrix may be stored in the memory 114 and used by the analysis application 116 when adapting or adjusting the tuning parameters. In one example, the position of the listeners and the type of listener, such as adult or children, is automatically identified, e.g. by means of a camera sensor. In another example, they are identified by means of an audio analysis that identifies the passengers based on an audio input.

In one example, the tuning parameters are adapted to metadata of the audio signal. The audio metadata may comprise one or more of a genre of an audio signal, a track number, and a format of the audio signal. The metadata are directly available with the audio signal. With the audio metadata, it is possible to adapt an audio effect to a genre-specific setting. In the case of an immersion effect, a lot of envelopment may be desired for electronic music, while a frontal stage behavior, in which the sound seems to come from a frontal stage may be preferable for classical music. For a podcast content, it might be preferable not to have any immersion effect at all.

In one example, the tuning parameters are adapted to properties of the audio content. The audio content data may comprise one or more of a type of content of the audio signal, a level and a compression of the signal, a spectral distribution, a number of channels, stereo information, a direct to ambience ratio, a beat rate, a tonality distribution and characteristics of sound sources. The type of content may be music, podcasts, news, or advertising. The system can be mono, stereo, or multi-channel. The stereo information may comprise width, mid/side balance, correlation, and phase. The direct signal is the signal component in a room that reaches the listener directly from the source without being reflected on the walls, floor or ceiling. The ambience signal is the sum of all reflections in the room. The direct to ambience ratio is the ratio between these two signal components and determines, for example, the perceived distance of a sound source in the room. These properties are not available as metadata but may be extracted from the audio signal through corresponding signal processing algorithms.

In one example, the tuning parameters are adapted in real-time to driving conditions and to an environmental context. This corresponds to the case in which the adaptation takes place in a car. The driving condition and environmental context data may comprise one or more of a driving mode, acceleration conditions, and environmental conditions. The driving mode may be sport mode or eco-mode. With this, it is possible to provide a highly immersive and personalized in-cabin experience for a car passenger.

In one example, the tuning parameters are adapted to the audio system itself. The audio system data may comprise one or more of a number of speakers, a position of the speakers, a nature of the speakers (technical characteristics of the speakers), a number of listening positions, and a position of the listening positions. This adaptation type is particularly important in the case of multi-channel audio effects, since the effect characteristics of an immersion effect, such as envelopment, perceived ambience, and center position, strongly depend on the number and position of the speakers. Further, the nature of the speakers, in particular the size of the speakers and the speaker technology, plays a significant role in the immersion effect, in particular for bass management. In a car environment, the listening position data, such as the number and position of the seats in the car, are directly linked to the type of system. A system-based adaptation makes it possible to switch between different systems without the listener noticing the change of system. For example, the listener may consume audio via Bluetooth headphones and then switch to a multi-channel system with speakers in a car.

In one example, the first data are at least one of sensor data, data input by a user and data obtained by machine learning. The data input to the computing device 110 may be sensor data collected by sensors of the environment. For example, vehicles already comprise a large number of sensors that are used to control aspects of the vehicle and may also be used by the computing device 110 to adapt the sound effects. Data may be collected in a central manner, for example from a cloud computing platform or via vehicle-to-everything or vehicle-to-vehicle communication if the system is arranged in a car. Some of the data, for example user preference data, may also be input by the user to the computing device 110 via an HMI. The data may also be provided by machine learning algorithms, which have access to a large number of data, such as system data or user preference data. The data may also already be available to the computing device 110 or to the audio processing system 300, as is the case for audio metadata. The computing device may retrieve data from the audio processing system 300 if necessary.

A very large number of possible input parameters is usually available. In particular, vehicles are highly electronically connected systems with a large number of sensors and user interaction possibilities. The first data that are input to the computing device 110 comprise one or a plurality of parameters that are chosen from the plurality of possible input parameters. In one example, the first data only comprise parameters that are linked to one given type of adaptation as set out above. In another example, the first data comprise parameters linked to different types of adaptation. The choice of the parameters strongly influences the adaptation of the tuning parameters. In one example, each input parameter of the first data is associated with a corresponding weighting value and the weighting values are taken into account during the adaptation process. In one example, the choice of the input parameters of the first data and of the weighting values depends on the desired audio effect. In particular, an input parameter might be important for one audio effect, but not for another audio effect. The input parameters of the first data may be received by the computing device 110 continuously or at predetermined intervals of time. The predetermined intervals may be provided by a clock generator of the computing device 110.

When the computing device 110 detects a change in at least one of the input parameters, the tuning parameters are adjusted. In one example, the first data comprise a plurality of input parameters, and the at least one tuning parameter is adjusted if, for at least a first parameter of the plurality of input parameters, a difference between a first value of the first parameter at the first time and second value of the first parameter at the second time exceeds a predetermined threshold for this input parameter. This prevents that an adaptation takes place at each small variation of the parameters, thereby reducing the overall calculation effort. The predetermined thresholds may be predefined and stored in the memory 114.

In one example, the computing device 110 is configured to perform the analysis and detect whether a change has occurred at regular intervals, such as every 1 second, every 5 seconds, every 60 seconds, every 5 minutes, etc. The intervals may be provided by a clock generator of the computing device 110. With this, it is possible to prevent that an adaptation takes place if the change is only temporary. For example, the user may change one of the user preferences by mistake and revert it immediately after. Further, in an example that can be combined with the previous example, the computing device 110 may be configured to detect whether a change has occurred in response to a sudden change such as a change in environmental condition or a change in vehicle state, such as a change in driver chosen speed. A sudden change may be detected by a sensor which may send a corresponding signal to the computing device 110, thereby causing the computing device 110 to perform an analysis. With this, a very dynamic and flexible adaptation is possible and the tuning parameters may be updated in real-time at each interval and in response to various state changes.

In one example, the computing device 110 is further configured to determine initial tuning parameters based on the first stream of first data. The initial parameters will then be adjusted depending on the changes of the parameters of the first data. In another example, the initial tuning parameters are predetermined, for example by using machine learning algorithms. Since the tuning parameters are dynamically adapted, there is no need for a precise pre-tuning of the audio processing system 300. With this, the production of the audio processing system 300 may be considerably simplified.

The analysis application 116 may include any feasible algorithm configured to perform an analysis on the input data, determine whether there is a change in the input data (first stream of first data) and adjust the tuning parameters based on the change in the input data. In one example, when the analysis application 116 is executed by the computing device 110, it causes the computing device 110 to adjust the at least one tuning parameter based on a look-up table 118. The look-up table 118 may be stored in the memory 114. It may be based on previous data of the system. In one example, the look-up table 118 is established by a user or a tuning engineer. In another example, it is established using machine learning algorithms. The look-up table 118 may associate values of the input parameters of the first data to values of one or several tuning parameters. The look-up table 118 may also associate values of the input parameters of the first data to values of differences of one or several tuning parameters. This means that, when the input parameters have reached certain values, the tuning parameters are not set to particular values but raised by a particular value (which may be negative).

In one example, when the analysis application 116 is executed by the computing device 110, it causes the computing device 110 to adjust the at least one tuning parameter by applying one or more machine learning (ML) algorithms 120 to the first stream of first data. In one example, the ML algorithms 120 are trained based on acquired data from real and/or simulated scenarios in which various data, such as user preference data, listening position data, audio metadata, audio content data, driving condition and environmental context data, and audio system data, are used as training inputs and tuning parameters are used as training outputs. The ML algorithms 120 may then ingest the received first stream of first data, analyze the first data, determine whether there is a change in the first data and output tuning parameters.

The ML algorithms 120 may continuously learn from the ingested and outputted data. In some examples, the data may be collected locally within the listening environment in order to repeatedly update the ML algorithms 120 for the specific listening environment. The ML algorithms 120 may also ingest data in a central manner, for example from a cloud computing platform or via vehicle-to-everything communication in the case of a vehicle to ingest data external to the listening environment. Over time, more and more data may be collected and analyzed by the computing device 110. The computing device 110 may thus take into account historic data as well as real-time data when adjusting the tuning parameters. Thus, the computing device 110 may become more adept over time at adjusting tuning parameters. This self-improving mechanism may ensure that the computing device 110 remains accurate and relevant even if conditions change and as new data become available.

The ML algorithms 120 may learn from specific conditions and patterns associated with individual systems, users and audio inputs, and may further refine the adjustments of the tuning parameters in order to align with the characteristics of the particular system, user and audio input. While not specifically described herein, it should be understood that the use of ML algorithms is one option and other algorithms aside from ML algorithms may also be used to adjust the tuning parameters.

Although the application mostly focusses on the example of the immersion effect, the audio processing system 300 may be able to provide a plurality of other audio effects. For each audio effect, the computing device 110 may carry out a different adaptation process based on different first data and different tuning parameters. The computing device 110 may also configured to adjust tuning parameters of further algorithms based on the input parameters, and to output them to a corresponding processing system. In one example, the computing device 110 is configured to control lighting or visual effects of an HMI. In one example, the further processing system comprises light elements and is configured to control the light elements based on the tuning parameters when executing the further algorithm.

In one example, the system 100 is further configured to enable a user to provide a user feedback. The user feedback may then be used as part of the first data. In one example, the listener may be informed about the adjustments of the audio processing system 300, e.g. via an HMI with a screen showing the adjustments carried out by the system 100 and/or the audio processing system 300. The listener (user) may then be allowed to react and to provide a feedback, for example via the HMI. This feedback may be used for the adaptation process to improve the adaptation.

In order to reduce the computational complexity of the adaptation, the adaptation process may be split into sub-processes (use cases). In one example, the computing device 110 is further configured to receive at least a second stream of second data. In the example of an immersion effect, the second data may comprise at least one of: user preference data, listening position data, audio metadata, audio content data, driving condition and environmental context data, and audio system data. The first data is different from the second data. This means that at least one input parameter of the second data is not part of the set of input parameters of the first data. In one example, the first data are related to one type of adaptation and the second data are related to another type of adaptation. In another example, the first and/or second data relate to different types of adaptation. The computing device 110 is further configured to perform an analysis on the second stream of second data at a third time and at a fourth time that is different from the third time. In one example, the third and fourth time are the same as the first and second times at which the analysis on the first stream of first data is carried out. The third and fourth times may be generated by a clock generator in the same way as the first and second times. The computing device 110 is also configured to, if a change in the second stream of second data is detected between the third time and the fourth time, adjust at least one further tuning parameter of the audio tuning algorithm of the audio processing system. In one example, the tuning parameters that are adjusted based on a change in the first stream of first data and the further tuning parameters that are adjusted based on a change in the second stream of second data are not identical. With this, the adaptation can be split into two separate steps, which can decrease the complexity of the calculation.

In one example, the computing device 110 is further configured to associate the first data to a first weighting value and to associate the second data to a second weighting value. The at least one tuning parameter and the at least one further tuning parameters may then be adjusted based on the first weighting value and on the second weighting value. This makes it possible to prioritize some of the input parameters. For example, the user preferences can be considered to have more weight than the content of the audio input. The weighting values may be adjusted automatically or by the user.

In one example, the computing device 110 is configured to receive a plurality of streams of data. The data of each stream comprises a plurality of input parameters. In the example of the immersion effect, the input parameters for each stream may comprise input parameters that are chosen from at least one of: user preference data, listening position data, audio metadata, audio content data, driving condition and environmental context data, and audio system data. In one example, the data of each stream comprise only one of: user preference data, listening position data, audio metadata, audio content data, driving condition and environmental context data, and audio system data. The data of one stream differ from the data of another stream. However, some of the data of a stream may overlap with the data of at least one other stream. The number of streams and the input parameters for the data streams may be chosen in advance and fixed. However, in some examples, the streams of data may be modified, for example by a user or during a system update. The computer device 110 may be configured to perform an analysis on each stream of data at a fifth time and at a sixth time that is different from the fifth time and determine, for each stream of data, whether there is a change between the fifth time and the sixth time. The computer device 110 may be further configured to, if there is a change in at least one of the streams of data, adjust at least one tuning parameter of an audio tuning algorithm of the audio processing system 300. In one example, each stream of data is associated with a plurality of tuning parameters, which is different from the plurality of tuning parameters associated with another stream of data. With this, the adaptation process can be split into different cases, which can reduce the complexity of the calculation of the computing device 110.

The plurality of data may comprise any kind of parameters and do not necessarily comprise user preference data, listening position data, audio metadata, audio content data, driving condition and environmental context data, or audio system data, as described above. In one example, a system 100 comprises a computing device 110 comprising one or more processors 112 and a memory 114. The computing device 110 is configured to receive a first stream of first data and a second stream of second data, wherein the first data is different from the second data. The computing device 120 is further configured to perform an analysis on the first stream of first data and on the second stream of second data at a first time and at a second time that is different from the first time. The computing device 110 is also configured to, if a change in the first stream of first data or a change in the second stream of second data is detected between the first time and the second time, adjust at least one tuning parameter of an audio tuning algorithm of an audio processing system 300. The audio processing system 300 is configured to process audio input by means of the audio tuning algorithm to generate audio output. In one example, the computing device 110 is configured to, if a change in the first stream of first data is detected between the first time and the second time, adjust at least one first tuning parameter, and, if a change in the second stream of second data is detected between the first time and the second time, adjust at least one second tuning parameter, wherein the first tuning parameter and the second tuning parameter are different from each other.

The system 100 presented in the application is able to dynamically adapt tuning parameters of an audio tuning algorithm of an audio processing system 300 to changes of a plurality of input parameters. The audio processing system 300 is configured to receive and process an audio input and to output an audio output that comprises, for example, a particular sound effect, such as an immersion effect, by executing a corresponding algorithm. The algorithm comprises a plurality of tuning parameters which can be adjusted by a computing device 110 of the system 100. The input parameters of the system 100 may be grouped in various data groups, wherein, for each data group, a change of at least one of the parameters of the data group leads to a change of the tuning parameters. Each data group comprises a plurality of parameters that may corresponds to a particular kind of adaptation, such as a user preference-based adaptation, a listening position-based adaptation, an audio metadata-based adaptation, an audio content-based adaptation, a driving condition and environmental context-based adaptation, or an audio system-based adaptation. For each parameter, a threshold may be defined, wherein an adjustment of the tuning parameters only occurs if the determined change exceeds the predetermined threshold. The input parameters may be monitored at regular intervals, wherein a change is determined when a value of a parameter differs between two monitored times. The data are input to a computing device 100 that comprises an analysis application 116 which, when executed by the computing device 110, causes the computing device 110 to determine, for each set of data, whether a change has occurred for at least one parameter and, if a change is detected, the tuning parameters are adjusted. With this, the tuning parameters are only adjusted when a change in one of the input parameters occurs. This can reduce the overall calculation effort of the computing device 110. The computing device 110 may adjust the tuning parameters based on a look-up table or by using ML algorithms that are trained with data from other systems as well as previous data for the system. The adjusted tuning parameters are then output to the audio processing system 300.

The system 100 provides a dynamic adaptation of the tuning parameters corresponding to a desired sound effect of the audio processing system 300, and solves the problems linked to the comprised tuning in conventional systems. The tuning process is based on a plurality of chosen changing attributes (parameters) that correspond to the actual listening situation, and not the laboratory situation of the tuning engineer in the case of a conventional comprised tuning. With this, the desired sound effect can be customized to the actual listening conditions and the listening experience can be greatly enhanced. This makes it possible to offer impressive effects that are not subject to compromised tuning. In particular, the proposed system 100 is able to provide a truly immersive, augmented reality musical experience. The proposed system 100 is able to take into account the complexity of a listening experience and the personalized requirement of the listeners, while keeping the computational complexity to a minimum. The adaptation process may be divided into several sub-adaptation processes that are independent from each other, thereby reducing the overall computational complexity of the adaptation process.

The dynamic adaptation of the sound effect is the baseline for multiple other use cases, such as the dynamic rendering of virtual sound sources, for example chimes. In addition to the adjustment information (tuning parameters) for an audio effect, the computing device 110 may also output further information, such as control signals for other algorithms or effects (lighting effects or visual effects on the HMI). Furthermore, the listener may be informed about the adjustments and may provide a feedback to the system 100, which can be used to improve the adaptation process.

Referring the FIG. 2, exemplary interactions of the tuning system in the case of an immersion effect are schematically illustrated. FIG. 2 provides an overview of different kinds of data that may be received and analyzed by the computing device 110. As mentioned above, ML models, algorithms and look-up tables may optionally be utilized.

As is described with respect to FIG. 1, the computing device 110 may receive several types of data, such as user preference data, listening position data, audio metadata, audio content data, driving condition and environmental context data, and audio system data. The user preference data may comprise one or more of an overall effect strength, a degree of immersion, a level of 3D content, a level of ambient components, characteristics of ambience components, spectral attributes, an amount of center extraction, a perceived location of center channel, a stage depth or height, a perceived listener's distance to a stage, a perceived position of the listener in relation to a musical event or instruments, and a behavior of an immersion effect depending on a music genre. The listening position data may comprise one or more of a position of a listener, an occupancy of a seating position, and a number of passengers in a car. The audio metadata may comprise one or more of a genre of an audio signal, a track number, and a format of the audio signal. The audio content data may comprise one or more of a type of content of the audio signal, a level and a compression of the signal, a spectral distribution, a number of channels, stereo information, a direct to ambience ratio, a beat rate, a tonality distribution and characteristics of sound sources. The driving condition and environmental context data may comprise one or more of a driving mode, acceleration conditions, and environmental conditions. The audio system data may comprise one or more of a number of speakers, a position of the speakers, a nature of the speakers, a number of listening positions, and a position of the listening positions.

The various retrieved data may be ingested by an analysis application 116 of the computing device 110 to adjust tuning parameters of an audio tuning algorithm of an audio processing system. The input data may be comprised in a single stream of data. Alternatively, the input data may be divided into a plurality of streams of data. In one example, each stream of data comprises data from one of the above data categories (types of data), respectively. In another example, at least one stream of data comprises data from a plurality of data categories. The input parameters of the different streams of data may be predetermined, for example by a tuning engineer, a user or a machine learning algorithm. The input parameters of the streams of data may also be adjusted during the processing in order to improve the listening experience. Further, the different streams of data are defined for a specific effect (sound effect or light effect) and may differ depending on the effect. In one example, for each effect, corresponding tuning parameters are adjusted based on the associated streams of data. The computing device 110 may be configured to process the streams of data associated with each effect simultaneously or at different times. Further, different effects may share one or several associated streams of data.

The analysis application 116 may instruct the computing device 110 to analyze the data and to determine whether there is a change in the data. The different types of data may be handled separately or together. In one example, the data are grouped in data groups that comprise parameters from one or several of the above data types. The data may be obtained, for example, as user input, for example via an HMI connected to the computing device 110, as sensor data, as data compiled by ML algorithms that have access to adaptation data of other systems, etc. In one example, the analysis application 116 causes the computing device 110 to adjust the at least one tuning parameter based on a look-up table or by applying one or more machine learning algorithms to the input data.

FIG. 3 illustrates an adaptation model of the system 100. As mentioned above, the computing device 110 receives one or a plurality of streams of data 1... p, wherein the data of each stream of data comprise a plurality of input parameters. Possible data types and input parameters are illustrated in FIG. 2. As shown on FIG. 3, the computing device 110 can be understood as a multi-dimensional matrix. For each stream of data 1...p, the individual input information (input parameters) represent the inputs of the matrix. In the depicted example, the input data comprise p streams of data, wherein the first stream of data comprises n input parameters and the stream of data p comprises m input parameters. Each change in one of the input parameters of one stream of data results in an adjustment or change in corresponding tuning parameters. In one example, the tuning parameters that are adapted based on a change of parameters of one stream of data are different from the tuning parameters that are adapted based on a change of parameters of another stream. With this, the adaptation processes for each stream of data are independent from each other. As mentioned above, for each input parameter, a predetermined threshold for the change of input parameter may be defined. A change in the input parameter may then only result in an adjustment or change in the tuning parameters if the difference of values of the input parameter during the considered interval of time exceeds the predetermined threshold for this input parameter.

In one example, the possible values of the tuning parameters are stored, for example, in the memory 114, and are dynamically recalled by the analysis application 116. In one example, if a change is detected in the first stream of data, the computing device 110 changes the values of the corresponding tuning parameters to corresponding stored values. In one example, the ranges of the tuning parameters are predetermined, so that the tuning parameters can only be varied within the corresponding predetermined ranges. In one example, not all possible values are stored in advance. For example, only a minimum possible value and a maximum possible value are stored for one or several of the tuning parameters. The values of the tuning parameters are obtained by interpolation based on the actual input values.

In one example, possible step changes of the tuning parameters are predefined and stored in the memory 114. A change in one of the input parameters then leads to a step change of one or several of the tuning parameters. For example, if the number of loudspeakers is changed to 5, the degree of envelopment (between 0 and 100%) of the immersion effect may be raised by 10%.

In one example, for some of the input parameters, the tuning adjustments are directly linear to the values of the input parameters or to the changes of the input parameters. In another example, for some of the input parameters, the tuning adjustments are not linear to the values of the input parameters or to the changes of the input parameters. The adaptation model may be represented by a plurality of matrixes or by a multi-dimensional matrix.

In one example, each stream of data corresponds to a specific type of adaptation and is represented by a corresponding matrix. In another example, the streams of data comprise a plurality of data that correspond to at least two different types of adaptation. In one example, a weighting value is associated with each matrix (i.e. each stream of data). The computing device 110 will then carry out the adaptation based on the weighting values of the matrixes. For example, the system architecture properties may be considered to be more important than the quality of the audio signal.

As mentioned above, the adaptation may be carried out by using a look-up table or by machine learning algorithms which have access to a large number of adaptation data of the system 100 and of other systems. In one example, the computing device 110 is configured to store the adjustments of the tuning parameters and the corresponding values of the input parameters in the memory 114. The stored values may be used to update the look-up table 118. Alternatively, the ML algorithms may use the stored adjustments for future adjustments. In one example, the computing device 110 is configured to communicate with an external device, such as a cloud device, which comprises a large number of adaptation data. The ML algorithms may then access the data of the cloud device and use them for the adaptation calculation. With this, the adaptation process may be quicker and more accurate.

Turning now to FIG. 4, a flowchart illustrating a method 400 for a tuning system for an audio processing system 110, such as the system 100 of FIG. 1, is shown. The method 400 may be executed by one or more processors of the system 100, such as processor(s) 112, based on instructions stored in memory, such as memory 114.

At 402, method 400 includes receiving a first stream of first data. In the example of the immersion effect, the first data may comprise at least one of: user preference data, listening position data, audio metadata, audio content data, driving condition and environmental context data, and audio system data. The first data comprise a plurality of input parameters that are chosen from one or several of these data types. The user preference data may comprise one or more of an overall effect strength, a degree of immersion, a level of 3D content, a level of ambient components, characteristics of ambience components, spectral attributes, an amount of center extraction, a perceived location of center channel, a stage depth or height, a perceived listener's distance to a stage, a perceived position of the listener in relation to a musical event or instruments, and a behavior of an immersion effect depending on a music genre. The listening position data may comprise one or more of a position of a listener, an occupancy of a seating position, and a number of passengers in a car. The audio metadata may comprise one or more of a genre of an audio signal, a track number, and a format of the audio signal. The audio content data may comprise one or more of a type of content of the audio signal, a level and a compression of the signal, a spectral distribution, a number of channels, stereo information, a direct to ambience ratio, a beat rate, a tonality distribution and characteristics of sound sources. The driving condition and environmental context data may comprise one or more of a driving mode, acceleration conditions, and environmental conditions. The audio system data may comprise one or more of a number of speakers, a position of the speakers, a nature of the speakers, a number of listening positions, and a position of the listening positions.

The first data may be received from one or more sensors, from a user input via a human-machine interface or from machine-learning algorithms. As an example, the listener preferences may be provided by a machine-learning algorithm based on previous user inputs. As another example, a car environment comprises a large plurality of sensors, such as camera sensors, RADAR sensors, temperature sensors, which are mounted to the vehicle and can provide data regarding the occupancy of the vehicle, the driving conditions and the environmental conditions. Further data may be obtained via an external server, which may be accessible through the Internet, or via vehicle-to-vehicle communication. Environmental data may be obtained from a GPS and/or in-vehicle navigation system.

The method may also include receiving at least a second stream of second data. In the example of the immersion effect, the second data may comprise at least one of: user preference data, listening position data, audio metadata, audio content data, driving condition and environmental context data, and audio system data. The first data is different from the second data. The first data and the second data may be associated to a first and a second weighting value.

At 404, method 400 includes performing an analysis on the first stream of first data at a first time and at a second time that is different from the first time. In one example, the first and the second times are provided by a first clock signal of a clock generator. In one example, the analysis is carried out at regular intervals. If there is at least a second stream of second data, the second stream of second may be analyzed at a third and at a fourth time. In one example, the third and the fourth times are provided by a second clock signal of the clock generator. The second clock signal may be identical with the first clock signal. The analysis of the first stream of first data comprises comparing, for each parameter of the first stream of first data, values of the input parameters between the first time and the second time.

At 406, method 400 includes determining whether there is a change in the first data. A change of the first data occurs if there is a change in at least one of the input parameters of the first data. In one example, a change is detected if a difference between a value of at least one input parameter of the first stream of first data at the first time and at the second time exceeds a predetermined threshold for this input parameter. The predetermined threshold may be stored in the memory 114. When at least a second stream of second data is received, a change is detected if there is a change in at least one of the input parameters of the first data or of the second data. If a change is detected, method 400 proceeds to 408. If no change is detected, method 400 ends.

At 408, method 400 includes adjusting at least one tuning parameter of an audio tuning algorithm of an audio processing system 300, wherein the audio processing system 300 processes audio input by means of the audio tuning algorithm to generate audio output. The audio processing system 300 may be configured to add a sound effect to the audio input, such as an immersion effect that is configured to give the listener the impression to hear the sound in a given listening environment, such as a concert hall or a bar. For each effect, a plurality of tuning parameters of the corresponding audio tuning algorithm are defined. The tuning parameters are then adjusted based on the detected change(s) of input parameters. Each change of the input parameters of the first data leads to a change of the tuning parameters. The input parameters may be associated with a weighting value depending on their importance and the tuning parameters may be adjusted based on the input parameters and their weighting values. In one example, the possible values of the tuning parameters are defined in advance and selected based on the changes in the input parameters of the first data. The tuning parameters may be adjusted via a look-up table that links values of the input parameters to values of the tuning parameters. The lookup table may be prestored in a memory. The look-up table may be based on previous adaptation processes and prepared by a tuning engineer. In another example, the tuning parameters are adjusted by one or several machine-learning algorithms. The machine-learning algorithms may be trained with previous data from the used system, as well as from data from other systems. The training data may be obtained via an external server. The ranges of adjustment of the tuning parameters may be defined in advance. In one example, the tuning parameters are adjusted by adding a predetermined amount (which may be negative) to the previous value of the tuning parameter. The initial values of the tuning parameters may be predetermined. In another example, the initial values of the tuning parameters may be determined based on the first stream of first data. When at least a second stream of second data is received, the first data and the second data may be weighted by corresponding weighting values, and the weighting values are taken into account in the adaptation process. The adjusted tuning parameters may then be output to the audio processing system and the audio processing system adapts the audio effect to the new tuning parameters. With the proposed method, the audio experience can be dynamically adapted to the user preferences and to the listening environment, so that a listening experience can be improved. Further, the computational complexity of the adaptation can be reduced, in particular by dividing the input data into different streams of data which are processed separately.

In order to further improve the user experience, the method may further comprise adjusting at least one further tuning parameter of a further algorithm based on the first stream of first data or based on the change of the first steam of first data, wherein the further algorithm, when executed, causes an audio system to carry out a particular action, such as a light effect or a sound effect. The further effect can thus also be adapted to the input data.

In addition, the method may include informing a user of the adjustment of the tuning parameters and giving the user an opportunity to provide a user feedback. With this, the user has the possibility to react to the effected changes. The user feedback may be fed to the computing device 110 and taken into account into the adaptation process, thereby helping to improve the adaptation process.

The present application describes a system and a method configured to dynamically adapt an audio effect, more especially tuning parameters of an audio tuning algorithm, to changes of input parameters. When a change of one of the input parameters is detected, the tuning parameters are adapted to the detected change. With this, the problem of compromised tuning in conventional audio systems can be solved. In particular, the audio effect can be adapted depending on the actual listening conditions, in particular to the user preferences, thereby improving the quality of the user experience. The desired audio effect can also be optimized to the listening environment so that it is less affected by ambient noise. By using machine-learning algorithms for the adaptation process, it is possible to process a very large number of input parameters and to take into account previously stored data for the system and for other similar systems, thereby further improving the quality of the adaptation. The input parameters may also be divided into different streams of data, wherein, for each stream of data, a corresponding adaptation process is carried out. The tuning parameters may thus be adapted to user preferences, to properties of the audio data to be played or to the listening environment. This may be helpful to further reduce the computational complexity of the adaptation process. The proposed system may be implemented in even in complex, multi-dimensional situations, such as in vehicles, which are already provided with a large number of sensor information. The system may also be implemented in other environments, such as a living-room or a movie theatre. It may be used to improve audio effects, such as an immersion effect, and thus provide an enhanced musical experience. However, other kinds of effects, such as light effects, might also be enhanced using the proposed system and methods. The proposed system is able to offer a highly personalized listening experience and to take into account a large number of environmental factors, while keeping the computational complexity as low as possible.

Although various embodiments have been illustrated and described with respect to one or more specific implementations, alterations and/or modifications may be made to the illustrated examples without departing from the spirit and scope of the features and structures recited herein. With particular regard to the various functions performed by the above described components or structures (units, assemblies, devices, circuits, systems, etc.), the terms (including a reference to a "means") used to describe such components are intended to correspond - unless otherwise indicated - to any component or structure that performs the specified function of the described component (e.g., that is functionally equivalent), even if it is not structurally equivalent to the disclosed structure that performs the function in the herein illustrated exemplary implementations of the present disclosure.

The following claims particularly point out certain combinations and sub-combinations regarded as novel and non-obvious. These claims may refer to "an" element or "a first" element or the equivalent thereof. Such claims should be understood to include incorporation of one or more such elements, neither requiring nor excluding two or more such elements. Other combinations and sub-combinations of the disclosed features, functions, elements, and/or properties may be claimed through amendment of the present claims or through presentation of new claims in this or a related application. Such claims, whether broader, narrower, equal, or different in scope to the original claims, also are regarded as included within the subject matter of the present disclosure.

## Claims

1. A system (100), comprising:
a computing device (110) comprising one or more processors (112) and a memory (114), wherein the computing device (110) is configured to:
receive a first stream of first data;
perform an analysis on the first stream of first data at a first time and at a second time that is different from the first time and determine whether there is a change in the first stream of first data between the first time and the second time; and
if there is a change in the first stream of first data between the first time and the second time, adjust at least one tuning parameter of an audio tuning algorithm of an audio processing system (300), wherein the audio processing system (300) is configured to process audio input by means of the audio tuning algorithm to generate audio output.

2. The system of claim 1, wherein
the first data comprising at least one of: user preference data, listening position data, audio metadata, audio content data, driving condition and environmental context data, and audio system data.

3. The system of claim 2, wherein
the user preference data comprise one or more of an overall effect strength, a degree of immersion, a level of 3D content, a level of ambient components, characteristics of ambience components, spectral attributes, an amount of center extraction, a perceived location of center channel, a stage depth or height, a perceived listener's distance to a stage, a perceived position of the listener in relation to a musical event or instruments, and a behavior of an immersion effect depending on a music genre.

4. The system of claim 2 or 3, wherein
the listening position data comprise one or more of a position of a listener, an occupancy of a seating position, and a number of passengers in a car.

5. The system of any one of claims 2 to 4, wherein
the audio metadata comprise one or more of a genre of an audio signal, a track number, and a format of the audio signal.

6. The system of any one of claims 2 to 5, wherein
the audio content data comprise one or more of a type of content of the audio signal, a level and a compression of the signal, a spectral distribution, a number of channels, stereo information, a direct to ambience ratio, a beat rate, a tonality distribution and characteristics of sound sources.

7. The system of any one of claims 2 to 6, wherein
the driving condition and environmental context data comprise one or more of a driving mode, acceleration conditions, and environmental conditions.

8. The system of any one of claims 1 to 6, wherein
the audio system data comprise one or more of a number of speakers, a position of the speakers, a nature of the speakers, a number of listening positions, and a position of the listening positions.

9. The system of any one of claims 1 to 8, wherein
the first data comprise a plurality of parameters, and
the at least one tuning parameter is adjusted if, for at least a first parameter of the plurality of parameters, a difference between a first value of the first parameter at the first time and second value of the first parameter at the second time exceeds a predetermined threshold.

10. The system of any one of claims 1 to 9, wherein
the memory (114) comprises an analysis application (116) which, when executed by the computing device (110), causes the computing device (110) to adjust the at least one tuning parameter based on a look-up table (118).

11. The system of any one of claims 1 to 9, wherein
the memory (114) comprises an analysis application (116) which, when executed by the computing device (110), causes the computing device (110) to adjust the at least one tuning parameter by applying one or more machine learning, ML, algorithms (120) to the first stream of first data.

12. The system of any one of claims 1 to 11, wherein
the computing device (110) is further configured to:
receive a second stream of second data, the first data being different from the second data;
perform an analysis on the second stream of second data at a third time and at a fourth time that is different from the third time; and
if a change in the second stream of second data is detected between the third time and the fourth time, adjust at least one further tuning parameter of the audio tuning algorithm of the audio processing system (300).

13. The system of claim 12, wherein
the computing device (110) is further configured to:
associate the first data to a first weighting value; and
associate the second data to a second weighting value;
wherein the at least one tuning parameter and the at least one further tuning parameters are adjusted based on the first weighting value and on the second weighting value.

14. An arrangement, comprising:
the system according to any one of claims 1 to 13; and
the audio processing system (300).

15. A method, comprising:
receiving a first stream of first data;
performing an analysis on the first stream of first data at a first time and at a second time that is different from the first time and determining whether there is a change in the first stream of first data between the first time and the second time; and
if there is a change in the first stream of first data between the first time and the second time, adjusting at least one tuning parameter of an audio tuning algorithm of an audio processing system (300), wherein the audio processing system (300) processes audio input by means of the audio tuning algorithm to generate audio output.
